# EUROPÄISCHE PATENTSCHRIFT

(11) **EP 1 642 313 B1**
(45) Veröffentlichungstag und Bekanntmachung des Hinweises auf die Patenterteilung: **22.12.2010**
(21) Anmeldenummer: 04740146.8
(22) Anmeldetag: 22.06.2004
(51) Int. Cl.: H01J 37/28, H01J 37/244

(54) **DETEKTORSYSTEM FÜR EIN RASTERELEKTRONENMIKROSKOP UND RASTERELEKTRONENMIKROSKOP MIT EINEM ENTSPRECHENDEN DETEKTORSYSTEM**
DETECTOR SYSTEM FOR A SCANNING ELECTRON MICROSCOPE AND SCANNING ELECTRON MICROSCOPE WITH A CORRESPONDING DETECTOR SYSTEM
SYSTEME DE DETECTEURS POUR UN MICROSCOPE ELECTRONIQUE A BALAYAGE ET MICROSCOPE ELECTRONIQUE A BALAYAGE POURVU D'UN SYSTEME DE DETECTEURS CORRESPONDANT

(30) Priorität: 09.07.2003 DE 10331137
(43) Veröffentlichungstag der Anmeldung: 05.04.2006
(73) Patentinhaber: Carl Zeiss NTS GmbH, 73447 Oberkochen (DE)
(72) Erfinder: JAKSCH, Heiner, 89522 Heidenheim (DE); BIHR, Johannes, 73431 Aalen (DE)
(74) Vertreter: Gnatzig, Klaus
(86) Internationale Anmeldenummer: PCT/EP2004/006715
(87) Internationale Veröffentlichungsnummer: WO 2005/006384

(56) Entgegenhaltungen:
- EP-A- 1 437 759
- US-A- 3 626 184
- US-A- 3 908 124
- PATENT ABSTRACTS OF JAPAN Bd. 0184, Nr. 34 (E-1592), 12. August 1994 (1994-08-12) & JP 6 139988 A (HITACHI LTD; others: 01), 20. Mai 1994 (1994-05-20)
- BOULIN C ET AL: "Parallel and Pipelined Front-endfor Multi-element Silicon Detectors in Scanning Electron Microscopy" IEEE, 24. Juni 1991 (1991-06-24), Seiten 60-65, XP010277064
- PENNYCOOK S J ET AL: "HIGH ANGLE DARK FIELD STEM FOR ADVANCED MATERIALS" JOURNAL OF ELECTRON MICROSCOPY, JAPANESE SOCIETY FOR ELECTRON MICROSCOPY. TOKYO, JP, Bd. 45, Nr. 1, 1. Februar 1996 (1996-02-01), Seiten 36-43, XP000584154 ISSN: 0022-0744

## Beschreibung

Die vorliegende Erfindung betrifft ein Detektorsystem für Rasterelektronenmikroskope, mit dem in einem Rasterelektronenmikroskop die durch eine Probe transmittierten Elektronen oder in Transmission - also in Ausbreitungsrichtung des Primärelektronenstrahles - aus der Probe austretende gestreute Elektronen detektiert werden können. Derartige sogenannte STEM Units werden beim Rasterelektronenmikroskop in der Probenkammer unter der Probe, also auf der von der Elektronenquelle abgewandten Seite der Probe, aufgenommen.

Ein derartiges Detektionssystem ist beispielsweise in dem Aufsatz von Ute Golla in Journal of Microscopy, Vol 173, (1999), Seiten 219 - 225 beschrieben. Nachteilig an diesem bekannten Detektionssystem ist, dass nur Bildinformationen im Hellfeldkontrast detektiert werden kann, also nur Elektronen detektiert werden, die elastisch an der Probe gestreut wurden.

Ein weiteres System für die Erzeugung von Transmissionsbildern in einem Rasterelektronenmikroskop ist in der noch nicht veröffentlichten deutschen Patentanmeldung 102 11 977.5 der Anmelderin beschrieben. Dieses System besteht aus einem Probenhalter oder mehreren Probenhaltern, untern denen eine relativ zu den Probenhaltern bewegbare Blende angeordnet ist. Die durch die Blende transmittierten Elektronen werden nachfolgend detektiert. Durch eine Relativverschiebung zwischen der Blende und dem Primärelektronenstrahl bzw. der Probe lassen sich hier unterschiedliche Kontraste erzeugen, insbesondere kann Bildinformation aufgezeichnete werden, die einem Hellfeldkontrast, einem Dunkelfeldkontrast oder einer Mischform davon entspricht.

Aus der WO 90/04261 ist für ein sogenanntes ESEM, das heißt für ein Elektronenmikroskop, das für den Betrieb mit relativ hohem Druck in der Probenkammer ausgelegt ist, ein Detektionssystem bekannt, das aus mehreren ringförmigen und segmentierten Elektroden besteht. Diese Detektoren dienen dazu, einen richtungsabhängigen Topographiekontrast der vom Primärelektronenstrahl bestrahlten Probe zu erzeugen.

Aus der US 3,908,124 ist ein 1Rasterelektronmikroskop bekannt, das unterhalb der Probe zwei in Strahlrichtung des Primärelektronenstrahls versetzt zueinander angeordnete Detektoren aufweist. Der probenseitige Detektor weist eine zentrale scheibenförmige oder dezentrale ringförmige Öffnung auf. Durch die Probe transmittierte Elektronen oder von der Probe in Vorwärtsrichtung gestreute Elektronen können durch die Öffnung den probenseitigen Detektor passieren und auf den dahinterliegenden zweiten Detektor fallen. Durch Differenzbildung der beiden Detektorsignale lässt sich eine Bildinformation erzeugen, die einem Phasenkontrast entspricht.

Aufgabe der Erfindung ist es, ein Detektionssystem für Rasterelektronenmikroskope zu schaffen, mit dem durch die Probe hindurch transmittierte oder von der Probe in Vorwärtsrichtung - also in Ausbreitungsrichtung des Primärelektronenstrahls - austretende Elektronen detektiert werden können und mit dem simultan die getrennte Gewinnung von Bildinformation möglich ist, die einem Hellfeldkontrast und einem Dunkelfeldkontrast entspricht. Aufgabe der Erfindung ist es gemäß eines weiteren Aspektes, ein Rasterelektronenmikroskop mit einem entsprechenden Detektor bereitzustellen. Der Detektor soll dabei so ausgebildet werden, dass auch eine parallele Detektion der auf der Primärelektronenseite von der Probe emittierten Röntgenstrahlung für eine sogenannte EDX-Analyse nicht beeinträchtigt wird.

Die vorgenannten Ziele werden durch ein Rasterelektronenmikroskop mit den Merkmalen des Anspruches 1 gelöst. Vorteilhafte Ausgestaltungen ergeben sich aus den Merkmalen der abhängigen Ansprüche.

Ein Rasterelektronenmikroskop nach der Erfindung weist eine Elektronenquelle und eine Elektronenoptik zur Bestrahlung einer Probe mit einem fokussierten Elektronenstrahl auf. In der Probenkammer des Rasterelektronenmikroskopes ist auf der der Elektronenquelle abgewandten Seite der Probe ein Detektorsystem angeordnet, das einen oder mehrere Detektoren in einer ersten Ebene aufweist, in dem oder zwischen denen ein Loch für einen freien Durchtritt von Elektronen besteht. Das Detektorsystem weist weiterhin einen zweiten Detektor in einer zweiten Ebene auf, die zur ersten Ebene beabstandet ist, wobei der zweite Detektor, in Ausbreitungsrichtung der von der Elektronenquelle kommenden Elektronen gesehen, hinter dem Loch des Detektors oder der Detektoren in der ersten Ebene angeordnet ist. Die Abmessungen des Loches für den freien Durchtritt der Elektronen im oder zwischen den ersten Detektoren in der ersten Ebene sind dabei so gewählt, dass an der Probe ohne nennenswerte Richtungsänderung gestreute Elektronen das Loch in dem oder zwischen den Detektoren in der ersten Ebene passieren und auf den zweiten Detektor auftreffen. Auf die Detektoren in der ersten Ebene treffen dann die an der Probe unter Richtungsänderung gestreuten Elektronen auf. Der Abstand des Detektorsystems und der Durchmesser oder die Kantenlänge des Loches zwischen den Detektoren in der ersten Ebene ist dann gerade so gewählt, dass die der Beleuchtungsapertur des Primärelektronenstrahles entsprechende Fläche in der Ebene des Detektorsystems, genauer gesagt in der ersten Ebene, in der die ersten Detektoren angeordnet sind, kleiner als die Fläche des Loches zwischen den ersten Detektoren ist.

Das Detektorsystem ist über einen Manipulator in der Probenkammer aufgenommen mit Hilfe dessen das Detektorsystem zur Feinjustierung senkrecht zur optischen Achse des Elektronenstrahls positionierbar ist, damit die Position des Loches zwischen den ersten

Detektoren zentrisch zur optischen Achse der Elektronenoptik positioniert werden kann. Mit Hilfe des Manipulators sollte das Detektorsystem aus dem Bewegungsbereich des in der Probenkammer aufgenommenen Probentisches entfernbar und mit hoher Präzision in einer voreingestellten Position wieder zentrisch zur optischen Achse repositionierbar sein. Dadurch ist auch bei in der Probenkammer eingebautem Detektorsystem grundsätzlich eine Kippung der Probe um die üblich einstellbaren Kippwinkel möglich, so dass die ansonsten mit dem Elektronenmikroskop realisierbaren Analytikmöglichkeiten nicht eingeschränkt werden.

Das Detektorsystem weist vorzugsweise vier erste Elektroncndetektoren auf, die in der ersten Ebene angeordnete sind. Die vier ersten Elektroncndetektoren sind dabei in ihrer Ebene versetzt zueinander angeordnet, so dass zwischen den vier Detektoren ein Loch für einen freien Durchtritt eines Elektronenstrahls entsteht. Das Detektorsystem weist darüber hinaus einen weiteren Elektronendetektor auf, der in einer zweiten, zur ersten Ebene beabstandeten zweiten Ebene zentrisch zu dem Loch zwischen den vier ersten Elektronendetektoren angeordnet ist.

Wenn ein entsprechendes Detektorsystem auf der von der Elektronenquelle abgewandten Seite einer Probe in der Probenkammer eines Rasterelektronenmikroskopes derart angeordnet ist, dass die Beleuchtungsapertur des Primärelektronenstrahls gerade das Loch zwischen den vier ersten Elektronendetektoren ausfüllt, detektieren die vier ersten Elektronendetektoren ausschließlich Elektronen, die an der Probe mit großer Richtungsänderung gestreut wurden und daher eine Bildinformation enthalten, die einem Dunkelfeldkontrast entspricht. Der hinter den ersten Detekrtoren liegende zweite Detektor delektiert ausschließlich Elektronen, die ohne oder nur mit geringer Richtungsänderung an der Probe gestreut wurden und daher eine Bildinformation enthalten, die einem Hellfeldkontrast entspricht. Dadurch ermöglicht das Detektorsystem die Aufnahme von Bildinformation entsprechend einem Hellfeldkontrast und einem Dunkelfeldkontrast simultan. Ohne weitere Proben- oder Detektormanipulation kann dadurch zwischen Hellfeldkontrast und Dunkelfeldkontrast umgeschaltet werden. Durch entsprechende Signalverarbeitung ist es natürlich auch möglich, Mischformen aus Hellfeld- und Dunkelfeldkontrast zu erzeugen.

Durch den Rasterbetrieb wird der Elektronenstrahl zusätzlich abgelenkt. Die Öffnung zwischen den ersten Detektoren ist daher etwas größer ausgelegt, als der Durchmesser für den Primärelektronenstrahl, der durch die Beleuchtungsapertur bestimmt ist, es erfordern würde. Da üblicherweise der Rasterbetrieb mit STEM-Abbildung bei mittleren und höheren Vergrößerungen im Bereich 1000-facher Vergrößerung oder darüber erfolgt, liegt die Auslenkung des Primärelektronenstrahls beim Rasterbetrieb in der Probenebene nur im Bereich einiger µm bis einiger weniger 10 µm. Nur entsprechend geringfügig größer als der der Beleuchtungsapertur entsprechende Durchmesser ist daher auch das Loch zwischen den ersten Detektoren auszulegen, damit auch beim Rasterbetrieb entsprechende unterschiedlichen Kontrast aufweisende Signale gewonnen werden.

Die Elektronendetektoren sind vorzugsweise als elektronenempfindliche Dioden ausgebildet. Dabei sollten die vier Dioden, die die vier ersten Elektronendetektoren bilden, identische für Elektronen empfindliche Flächen aufweisen, damit in radialer Richtung um den Primärelektronenstrahl herum eine identische Detektionsempfindlichkeit gewährleistet ist.

Die für Elektronen empfindlichen Flächen sowohl der vier ersten Elektronendetektoren als auch des zweiten Elektronendetektors sollten sämtlich der von der Elektronenquelle abgewandten Seite der Probe zugerichtet sein.

Der Durchmesser oder die Kantenlänge des weitern Elektronendetektors, der in der zweiten Ebene angeordnet ist, sollte größer als der Durchmesser oder die Kantenlänge des Loches zwischen den vier ersten Elektronendetelctoren in der ersten Ebene sein.

Bei Ausbildung der Elektronendetektoren als Dioden sollten die vier Dioden, die die vier ersten Detektoren bilden, jeweils rechteckige oder quadratische elektronenempfindliche Flächen aufweisen. Durch entsprechende versetzte Anordnung der vier einzelnen Dioden entsteht dann das für den freien Durchtritt der Elektronen erforderliche Loch. Auf diese Weise lässt sich ein sehr kleines Loch zwischen den vier Detektoren realisieren, ohne dass um das Loch herum ein zu großer Totbereich (also ein für den Elektronennachweis unempfindlicher Bereich) entsteht und ohne dass große für Elektronen unempfindliche Bereiche zwischen den vier ersten Elektronendetektoren entstehen.

Der Abstand zwischen der ersten und der zweiten Ebene sollte zwischen 0,1 und 5 mm betragen. Das Loch für den freien Durchtritt von Elektronen zwischen den vier ersten Detektoren sollte einen Durchmesser oder eine Kantenlänge zwischen 0,05 und 1 mm aufweisen.

Die Signalauswertung für die mit dem erfindungsgemäßen Detektor aufgezeichneten Bildsignale sollte wahlweise zwischen folgenden Modi umschaltbar sein:
In einem ersten Modus wird nur das Signal des zweiten unteren Detektors zur Bilderzeugung/Bilddarstellung genutzt. Das aufgezeichnete Bild entspricht dann einem Hellfeldbild. In einem zweiten Modus sollten die Signale aller vier ersten Detektoren addiert werden. Das aufgezeichnete Bild entspricht dann einem Dunkelfeldkontrast. In einem dritten Modus sollten nur die Signale eines einzigen, auswählbaren ersten Elektronendetektors zur Bilderzeugung herangezogen werden. In einem vierten Modus sollten die von zwei beliebigen ersten Detektoren erzeugten Signale additiv zur Bilderzeugung herangezogen werden. Diese beiden Modi entsprechen jeweils Dunkelfeldbildinformationen mit einer richtungsselektiven Wirkung. In einem fünften Modus sollten die Signale aller fünf Detektoren addiert zur Bilderzeugung genutzt werden. Das dann erzeugte Bild entspricht einer Mischform aus Hellfeld- und Dunkelfeldkontrast. Zu diesen aufgeführten Modi sollte es auch mögliche sein, dass das jeweilige Bildsignal vor der jeweiligen Addition invertiert wird. Dies entspricht dann eine Subtraktion dieses Detektorsignals von dem anderen Signal oder von den anderen Signalen.

Besonders vorteilhaft ist es, die von allen fünf Detektoren detektierten Signale in Abhängigkeit von der Auslenkung des Elektronenstrahls jeweils separat, beispielsweise mit Hilfe von fünf Bildspeicherkarten, zu speichern. Die Auswahl der geeigneten Kontrastierung kann dann auch im nachhinein verändert und dabei so gewählt werden, dass die gewünschte Bildinformation bestmöglich zum Vorschein kommt.

Nachfolgend werden Einzelheiten der Erfindung anhand des in den Figuren dargestellten Ausführungsbeispiels näher erläutert. Dabei zeigen:
- Figur 1:: den Schnitt durch ein Rasterelektronenmikroskop mit einem Detektorsystem in der Probenkammer;
- Figur 2:: eine Aufsicht auf ein Detektorsystem; und
- Figur 3:: eine vergrößerte Darstellung des Probenbereiches in der Probenkammer eines Rasterelektronenmikroskopes mit einem Detektorsystem.

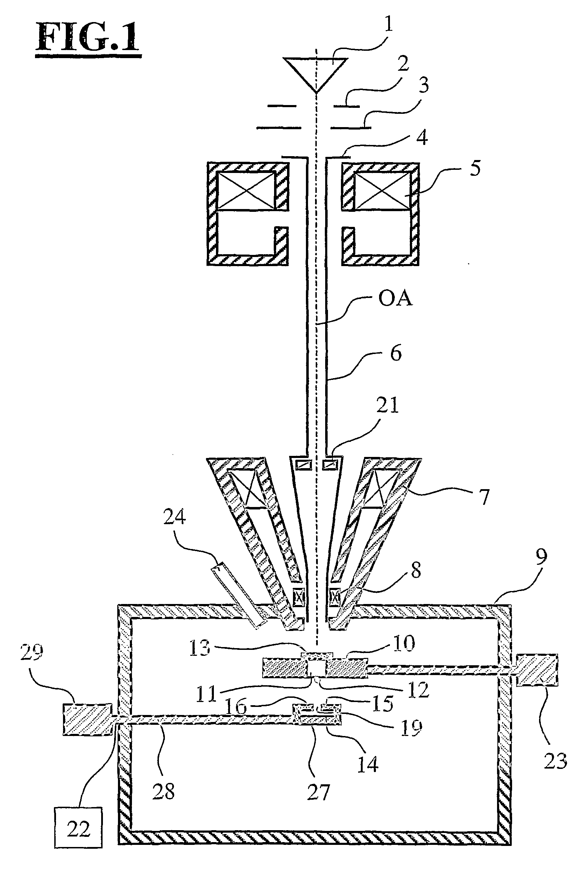

In der Figur 1 ist mit (1) die Elektronenquelle des Rasterelektronemnikroskopes bezeichnet. Die Elektronenquelle ist vorzugsweise eine Feldemissionsquelle oder ein sogenannter Schottky-Emitter mit einer Suppressorelektrode (2) und einer Extraktorelektrode (3). Mit Hilfe der Extraktionselektrode (3) und des daran angelegten Potentials werden Elektronen aus dem Emitter (1) emittiert und der Elektronenstrom gesteuert. Durch das an eine Anode (4) angelegte Potential werden die Elektronen auf Ihre Sollenergie beschleunigt.

Auf den Elektronenstrahlerzeuger (1-4) folgt eine magnetische Kondensorlinse (5) zur Einstellung der Apertur des Elektronenstrahls.

Das Rasterelektronenmikroskop weist des weiteren eine magnetische Objektivlinse (7) auf, durch die der Elektronenstrahl fokussiert wird. Innerhalb des Polschuhspaltes der Magnetlinse (7) sind die Spulen eines magnetischen Ablenksystems (8) angeordnet, durch das der Elektronenstrahl senkrecht zur optischen Achse (OA) auslenkbar ist, um eine Probe (13) abzuscannen.

In dem in der Figur 1 dargestellten Ausführungsbeispiel ist ein Strahlführungsrohr (6) vorgesehen, das sich von der Anode (4) durch die Bohrungen durch die Kondensorlinse (5) und die Objektivlinse (7) erstreckt und erst auf Höhe des Polschuhspaltes der Magnetlinse (7) oder probenseitig davon endet. Je nach Potentialbeaufschlagung zwischen der Anode (4) und der Magnetlinse (7) und dem in der Probenkammer (9) aufgenommenen Probenhalter (10) bildet das Strahlführungsrohr mit der probenseitigen Polschuhkante der Magnetlinse (7) eine zusätzliche elektrostatische Linse, durch die die Elektronen vom Säulenpotential auf die gewünschte Zielenergie abgebremst werden, mit der die Primärelektronen auf die auf dem Probenhalter (10) aufgenommene Probe (13) auftreffen.

In der Probenkammer des Rasterelektronmikroskops ist in bekannter Weise ein Probenhalter (10) mit einer zentralen Bohrung (11) aufgenommen. Mittels eines von außerhalb der Probenkammer bedienbaren Manipulators (23) ist der Probenhalter (10) in den drei zueinander senkrechten Raumrichtungen in bekannter Weise fein positionierbar, sowie um eine zur senkrecht zur optischen Achse (OA) stehende Kippachse (12) kippbar. Zudem ist der Probenhalter zu einer parallel zur optische Achse (OA) stehenden Achse drehbar.

Innerhalb des Strahlführungsrohres (6) ist oberhalb also quellenseitig der Objektivlinse (7) ein Inlensdetektor (21) angeordnet, durch den aus der Probe durch den Primärelektronenstrahl ausgelöste Sekundärelektronen detektierbar sind. Dazu werden die aus der Probe austretenden Sekundärelektronen durch die vom Strahlführungsrohr (6) gebildet elektrostatische Immersionslinse in das Strahlführungsrohr gesaugt und auf das Potential des Strahlführungsrohres beschleunigt.

Auf der von der Elektronenquelle (1) abgewandten Seite des Probenhalters (10) ist das erfindungsgemäße Detektorsystem (14) angeordnet. Das Detektorsystem (14) ist dabei ebenfalls über einen Manipulator (28), der über ein Bedienelement (29) von außerhalb der Probenkammer bedienbar ist, aufgenommen und in der Ebene senkrecht zur optischen Achse (OA) in zwei zueinander senkrechten Richtungen und in Richtung der optischen Achse (OA) positionierbar.

Das Detektorsystem weist vier in einer Ebene angeordnete Dioden (15), (16) auf, von denen in der Figur 1 nur zwei Dioden zu sehen sind, und zwischen denen sich ein quadratisches Loch (19) befindet. Des weiteren weist das Detektorsystem in einer zweiten, zur Ebene der vier ersten Dioden (15), (16) in Richtung der optischen Achse versetzten Ebene eine weitere Diode (27) auf, die das Loch zwischen den ersten Detektoren (15), (16) überdeckt und diejenigen Elektronen detektiert, die das Loch zwischen den ersten Dioden (15), (16) passieren.

Die mit den einzelnen Dioden (15), (16), (27) detelctierten Signale werden über in die Manipulatorstange (28) integrierte Signalleitungen (in der Figur 1 nicht dargestellt) aus der Probenkammer (9) herausgeleitet und der Signalverarbeitung (22) zugeführt.

Auf der Seite der Objektivlinse (7) ist über einen weiteren Port der Probenkammer (9) ein Röntgendetektor (24) für EDX-Analysen aufgenommen. Da das erfindungsgemäße Detektorsystem vollständig auf der von der Objektivlinse (7) abgewandten Seite des Probenhalters (10) angeordnet ist, können simultan zu der Signalgewinnung mit dem erfindungsgemäßen Detektorsystem auch Röntgenanalysen mit dem EDX-Detektor (24) durchgeführt werden.

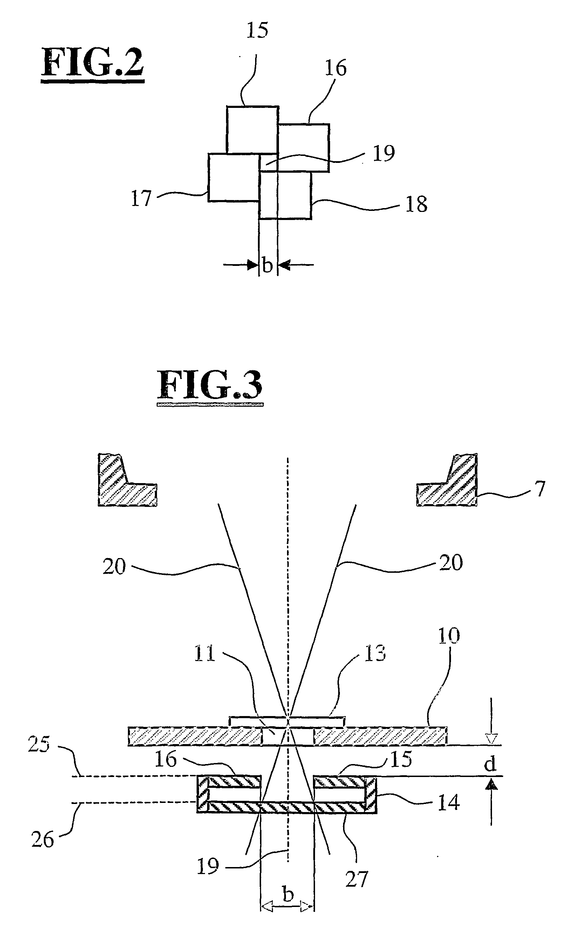

In der Aufsicht in Figur 2 sind die vier in der ersten Ebene angeordneten Dioden (15), (16), (17), (18) so dargestellt, dass man auf deren elektronenempfindlichen Flächen draufschaut. Die elektronenempfindlichen Flächen der Dioden (15), (16), (17), (18) sind bei eingebautem Detektorsystem zum Probenhalter (10) (Figur 1) gewandt.

Alle vier Dioden (15), (16), (17), (18) haben eine identische quadratische oder rechteckige elektronenempfindliche Fläche. Die vier Dioden (15), (16), (17), (18) sind jeweils leicht versetzt zueinander angeordnet, so dass zwischen den vier Dioden (15), (16), (17), (18) ein quadratisches Loch (19) entsteht. Der Versatz zwischen den Dioden (15), (16), (17), (18) ist dazu jeweils in Richtung der aneinander angrenzenden Kanten der Dioden. Abgesehen von dem gewünschte quadratischen Loch (19) im Zentrum zwischen den vier Dioden (15), (16), (17), (18) sind die Dioden (15), (16), (17), (18) unmittelbar aneinander angrenzend angeordnet, so dass zwischen den Dioden (15), (16), (17), (18) keine für Elelctronen unempfindliche Todbereiche entstehen. Der Versatz zwischen den Dioden (15), (16), (17), (18) beträgt weniger als 1 mm, vorzugsweise weniger als 400 µm, besonders bevorzugt etwa 200 µm, so dass das quadratische Loch eine Kantenlänge b entsprechend dem Versatz zwischen denen Dioden aufweist.

Wie man der vergrößerten Darstellung in Figur 3 entnehmen kann, ist der Abstand d zwischen dem Probenhalter (10) und dem Detektorsystem (14) in Abhängigkeit von der Kantenlänge des Loches (19) zwischen den Detektoren (15), (16) in der ersten Ebene (25) so gewählt, dass die an der Probe (13) mit geringer Änderung ihrer Bewegungsrichtung gestreuten Elektronen, die die Probe (13) in Transmission passiert haben, das Loch (19) zwischen den Detektoren (15), (16) in der ersten Ebene (25) passieren und auf den weiteren, in der zweiten Ebene (26) angeordneten weiteren Detektor (27) auftreffen. Der Abstand (d) zwischen dem Probenhalter (10) und dem Detektorsystem (14) ist dazu in Abhängigkeit von der Kantenlänge (b) des Loches (19) und der Beleuchtungsapertur so gewählt, dass die der Beleuchtungsapertur (20) in der ersten Ebene entsprechende Fläche der Fläche des Loches (19) nahezu entspricht. An der Probe unter deutlicher Änderung ihrer Bewegungsrichtung in Vorwärtsrichtung gestreute Elektronen treffen dann auf die in der ersten Ebene (25) angeordneten Detektoren (15) bis (18) auf. Die an der Probe ohne oder mit nur unwesentlich geringer Änderung ihrer Ausbreitungsrichtung gestreuten Elektronen passieren hingegen das Loch (19) und treffen auf den in der zweiten Ebene (26) angeordneten weiteren Detektor (27) auf.

Die Signalauswertung (22) weist für jeden der insgesamt fünf unabhängigen Detektoren (15 -18, 27) eine eigene Bildspeicherkarte oder einen eigenen Speicherbereich auf einer entsprechend großen einzigen Bildspeicherkarte auf, so dass simultan die mit jedem einzelnen Detektor delektierten Signale in jeder Scanposition des Primärelektronenstrahls erfasst und gespeichert werden. Die Signalauswertung (22) erlaubt dann die Bilddarstellung in fünf verschiedenen Modi, für die sämtliche Informationen nahezu direkt vorliegen, so dass ohne aufwändige zwischengeschaltete Bildverarbeitung zwischen den verschiedenen Modi gewechselt werden kann. In einem ersten Darstellungsmodus wird lediglich das Signal des weiteren Detektors (27) zur Bilderzeugung herangezogen, wodurch das dargestellte Bild einen Hellfeldkontrast aufweist. In einem zweiten Modus wird die Summe der Signale der vier ersten Detektoren (15) bis (18) zur Bilderzeugung herangezogen, wodurch das dargestellte Bild einem Dunkelfeldkontrast entspricht. In einem dritten und vierten Modus werden auswählbare Signale jeweils nur eines einzelnen Detektors (15), (16) der in der ersten Ebene (25) angeordneten Detektoren (15) bis (18) oder die Summe der Signals von zwei in der ersten Ebene angeordneten Detektoren (15, 16) zur Bilderzeugung herangezogen, wodurch das Bild einen Dunkelfeldkontrast mit unterschiedlichen richtungsselektiven Wirkungen erhält; dieses entspricht bei Kristallen einem Orientierungskontrast. In einem fünften Modus wird die Summe der Signale aller in der ersten Ebene angeordneten Detektoren (15) bis (18) und des in der zweiten Ebene (26) angeordneten Detektors (27) zur Bilderzeugung herangezogen, wodurch das Bild eine Mischform aus einem Hellfeldkontrast und einem Dunkelfeldkontrast erhält. Zusätzlich können die Ausgangssignale beliebiger Detektoren invertiert werden, so dass neben der Summenbildung auch die Differenzbildung und die Darstellung mit invertierten Kontrasten möglich ist.

## Patentansprüche

1. Rasterelektronenmikroskop mit einer Elektronenquelle (1) und einer Elektronenoptik (5), (7) zur Bestrahlung einer Probe (13) mit einem fokussierten Elektronenstrahl (20), sowie einem in der Probenkammer (9) auf der der Elektronenquelle (1) abgewandten Seite der Probe (13) angeordneten Detektorsystem (14), wobei das Detektorsystem (14) einen oder mehrere Detektoren (15) bis (18) in einer ersten Ebene (25) aufweist, in dem oder zwischen denen ein Loch (19) für einen freien Durchtritt von Elektronen vorhanden ist, und einen zweiten Detektor (27) in einer zweiten, zur ersten Ebene (25) beabstandeten Ebene (26) aufweist, wobei der zweite Detektor (27), in Ausbreitungsrichtung der von der Elektronenquelle (1) kommenden Elektronen gesehen, hinter dem Loch (19) des oder der Detektoren (15, 16, 17, 18) in der ersten Ebene (25) angeordnet ist, und wobei die Abmessungen des Loches (19) für den freien Durchtritt von Elektronen in dem oder zwischen den Detektoren (15, 16, 17, 18) in der ersten Ebene (25) und der Abstand des oder der Detektoren (15, 16, 17, 18) in der ersten Ebene (25) von der zu bestrahlenden Probe (13) so gewählt ist, dass an der Probe ohne oder mit nur geringer Änderung ihrer Ausbreitungsrichtung gestreute Elektronen das Loch (19) in dem oder zwischen den Detektoren (15, 16, 17, 18) in der ersten Ebene (25) passieren und auf den zweiten Detektor (27) auftreffen und dass an der Probe, unter Änderung ihrer Ausbreitungsrichtung gestreute Elektronen auf den oder die Detektoren (15, 16, 17, 18) in der ersten Ebene auftreffen, **dadurch gekennzeichnet, dass** das Detektorsystem (14) an einem Manipulator (28), (29) in der Probenkammer (9) aufgenommen ist und der Manipulator (28), (29) in der zur optischen Achse (OA) des Elektronenstrahls senkrechten Ebene in zwei zueinander senkrechten Richtungen justierbar ist.

2. Rasterelektronenmikroskop nach Anspruch 1, wobei das Detektorsystem (14) mittels des Manipulators (28), (19) aus dem Bewegungsbereich eines in der Probenkammer (9) aufgenommenen Probentisches (10) entfernbar und mit hoher Präzision in einer voreingestellten Position repositionierbar ist.

3. Rasterelektronenmikroskop nach einem der Ansprüche 1-2, wobei in der ersten Ebene (25) mehrere, vorzugsweise vier Detektoren (15, 16, 17, 18) angeordnet sind.

4. Rasterelektronenmikroskop nach Anspruch 3, wobei die in der ersten Ebene angeordneten Detektoren (15, 16, 17, 18) alle gleich große für Elektronen empfindliche Flächen aufweisen.

5. Rasterelektronenmikroskop nach einem der Ansprüche 1- 4, wobei die Elektronendetektoren (15, 16, 17, 18) Dioden sind.

6. Rasterelektronenmikroskop nach einem der Ansprüche 1- 5, wobei das Loch zwischen den Detektoren (15, 16, 17, 18) in der ersten Ebene (25) einen Durchmesser oder eine Kantenlänge von < 1 mm aufweist.

7. Rasterelektronenmikroskop nach einem der Ansprüche 1- 6, wobei die für Elektronen empfindlichen Flächen der in der ersten Ebene angeordneten Detektoren (15, 16, 17, 18) außerhalb des Loches (19) unmittelbar aneinander angrenzen, so dass die zwischen den Detektoren entstehenden für Elektronen unempfindliche Bereiche senkrecht zu den Kanten der Detektoren Abmessungen von unter 200 µm aufweisen.

8. Rasterelektronenmikroskop nach einem der Ansprüche 1- 7, wobei eine Signalauswertung vorgesehen ist, die eine Bilderzeugung in mindestens fünf Modi ermöglicht, wobei in einem ersten Modus lediglich das Signal des weiteren Detektors (27) zur Bilderzeugung herangezogen wird, in einem zweiten Modus die Summe der Signale der ersten Detektoren (15, 16, 17, 18) zur Bilderzeugung herangezogen wird, in einem dritten und vierten Modus, auswählbare Signale eines einzelnen der ersten Detektoren (15), (16) der in der ersten Ebene (25) angeordneten Detektoren (15, 16, 17, 18) oder die Summe von zwei in der ersten Ebene angeordneten Detektoren (15, 16, 17, 18) zur Bilderzeugung herangezogen werden und in einem fünften Modus die Summe der Signale der in der ersten Ebene angeordneten Detektoren (15, 16, 17, 18) und des in der zweiten Ebene (26) angeordneten Detektors (27) zur Bilderzeugung herangezogen wird.

9. Rasterelektronenmikroskop nach einem der Ansprüche 1 bis 8, wobei das Detektorsystem vier Elektronendetektoren (15, 16, 17, 18) aufweist, die in der ersten Ebene (25) angeordnet sind, wobei die vier Elektronendetektoren (15, 16, 17, 18) versetzt zueinander angeordnet sind, so dass zwischen den Elektronendetektoren ein Loch (19) für einen freien Durchtritt eines Elektronenstrahls vorhanden ist

10. Rasterelektronenmikroskop nach einem der Ansprüche 1 bis 9, wobei die vier Elektronendetektoren in der ersten Ebene (15, 16, 17, 18) rechteckige oder quadratische für Elektronen empfindliche Flächen aufweisen.

11. Rasterelektronenmikroskop nach einem der Ansprüche 1- 10, wobei das Loch (19) für den freien Durchtritt von Elektronen quadratisch ist.

12. Rasterelektronenmikroskop nach einem der Ansprüche 1- 11, wobei der Abstand zwischen der ersten Ebene (25) und der zweiten Ebene (26) zwischen 0,1 und 5 mm beträgt.

13. Rasterelektronenmikroskop nach einem der Ansprüche 1-12, wobei das Loch (19) für den freien Durchtritt von Elektronen einen Durchmesser oder eine Kantenlänge zwischen 0,05 und 1 mm aufweist.

## Claims

1. Scanning electron microscope having an electron source (1) and an electron optics (5), (7) for irradiating a sample (13) with the aid of a focused electron beam (20), as well as a detector system (14) arranged in the sample chamber (9) on the side of the sample (13) averted from the electron source (1), the detector system (14) having one or more detectors (15) to (18) in a first plane (25) in which or between which a hole (19) is present for a free passage of electrons, and a second detector (27) in a second plane (26) spaced apart from the first plane (25), the second detector (27), when seen in the direction of propagation of the electrons coming from the electron source (1), being arranged downstream of the hole (19) of the detector or detectors (15, 16, 17, 18) in the first plane (25), and the dimensions of the hole (19) for the free passage of electrons in the or between the detectors (15, 16, 17, 18) in the first plane (25), and the spacing of the detector or detectors (15, 16, 17, 18) in the first plane (25) from the sample (13) to be irradiated being selected such that electrons scattered on the sample without or with only a slight change to their direction of propagation pass the hole (19) in the, or between the, detectors (15, 16, 17, 18) in the first plane (25) and strike the second detector (27), and that electrons scattered on the sample with a change in their direction of propagation strike the detector or detectors (15, 16, 17, 18) in the first plane, **characterized in that** the detector system (14) is held on a manipulator (28), (29) in the sample chamber (9), and the manipulator (28), (29) can be adjusted in two mutually perpendicular directions in the plane perpendicular to the optical axis (OA) of the electron beam.

2. Scanning electron microscope according to Claim 1, in which the detector system (14) can be removed by means of the manipulator (28), (19) from the range of movement of a sample table (10) held in the sample chamber (9) and can be repositioned with higher precision in a preset position.

3. Scanning electron microscope according to either of Claims 1 and 2, in which a plurality of, preferably four, detectors (15, 16, 17, 18) are arranged in the first plane (25).

4. Scanning electron microscope according to Claim 3, in which the detectors (15, 16, 17, 18) arranged in the first plane are all electron-sensitive surfaces of the same size.

5. Scanning electron microscope according to one of Claims 1-4, in which the electron detectors (15, 16, 17, 18) are diodes.

6. Scanning electron microscope according to one of Claims 1-5, in which the hole between the detectors (15, 16, 17, 18) in the first plane (25) has a diameter or an edge length of < 1 mm.

7. Scanning electron microscope according to one of Claims 1-6, in which the electron-sensitive surfaces of the detectors (15, 16, 17, 18) arranged in the first plane border one another directly outside the hole (19) such that the electron-insensitive regions resulting between the detectors have dimensions of less than 200 µm perpendicular to the edges of the detectors.

8. Scanning electron microscope according to one of Claims 1-7, in which there is provided a signal evaluation which enables an image generation in at least five modes, in a first mode only the signal of the further detector (27) being used for the image generation, in a second mode the sum of the signals of the first detectors (15, 16, 17, 18) being used for the image generation, in a third and fourth mode selectable signals of an individual one of the first detectors (15), (16) of the detectors (15, 16, 17, 18) arranged in the first plane (25) or the sum of two detectors (15, 16, 17, 18) arranged in the first plane being used for the image generation, and in a fifth mode the sum of the signals of the detectors (15, 16, 17, 18) arranged in the first plane and of the detector (27) arranged in the second plane (26) being used for the image generation.

9. Scanning electron microscope according to one of Claims 1 to 8, in which the detector system has four electron detectors (15, 16, 17, 18) which are arranged in the first plane (25), the four electron detectors (15, 16, 17, 18) being arranged offset from one another such that a hole (19) for a free passage of an electron beam is present between the electron detectors.

10. Scanning electron microscope according to one of Claims 1 to 9, in which the four electron detectors in the first plane (15, 16, 17, 18) have rectangular or square electron-sensitive surfaces.

11. Scanning electron microscope according to one of Claims 1-10, in which the hole (19) for the free passage of electrons is square.

12. Scanning electron microscope according to one of Claims 1-11, in which the spacing between the first plane (25) and the second plane (26) is between 0.1 and 5 mm.

13. Scanning electron microscope according to one of Claims 1-12, in which the hole (19) for the free passage of electrons has a diameter or an edge length of between 0.05 and 1 mm.

## Revendications

1. Microscope électronique à balayage avec une source d'électrons (1) et une optique électronique (5), (7) pour l'irradiation d'un échantillon (13) avec un faisceau électronique focalisé (20), ainsi qu'un système détecteur (14) disposé dans la chambre d'échantillon (9) sur la face de l'échantillon (13) éloignée de la source d'électrons (1), le système détecteur (14) comportant un ou plusieurs détecteurs (15) à (18) dans un premier plan (25), dans lequel ou entre lesquels se trouve un trou (19) pour un libre passage d'électrons, et comportant un deuxième détecteur (27) dans un deuxième plan (26) distant du plan (25), le deuxième détecteur (27) étant disposé derrière le trou (19) du ou des détecteurs (15, 16, 17, 18) dans le premier plan (25) par rapport à la direction de propagation des électrons provenant de la source d'électrons (1), et les dimensions du trou (19) pour le libre passage d'électrons dans ou entre les détecteurs (15, 16, 17, 18) dans le premier plan (25) et la distance du ou des détecteurs (15, 16, 17, 18) dans le premier plan (25) de l'échantillon (13) à irradier étant choisies de telle sorte que des électrons diffusés sur l'échantillon sans ou rien qu'une faible modification de leur direction de propagation, traversent le trou (19) dans ou entre les détecteurs (15, 16, 17, 18) dans le premier plan (25) et frappent le deuxième détecteur (27) et que des électrons diffusés sur l'échantillon avec modification de leur direction de propagation, frappent le ou les détecteurs (15, 16, 17, 18) dans le premier plan, **caractérisé en ce que** le système détecteur (14) est hébergé dans la chambre d'échantillon (9) sur un manipulateur (28), (29) et le manipulateur (28), (29) est ajustable dans deux directions mutuellement perpendiculaires dans un plan perpendiculaire à l'axe optique (OA) du faisceau électronique.

2. Microscope électronique à balayage selon la revendication 1, dans lequel le manipulateur (28), (29) permet d'enlever le système détecteur (14) d'une table d'échantillon (10) hébergée dans la chambre d'échantillon (9) et permet de le repositionner avec grande précision dans une position préréglée.

3. Microscope électronique à balayage selon une des revendications 1-2, dans lequel plusieurs détecteurs, de préférence quatre (15, 16, 17, 18) sont disposés dans le premier plan (25).

4. Microscope électronique à balayage selon la revendication 3, dans lequel les détecteurs (15, 16, 17, 18) disposés dans le premier plan comportent tous des surfaces sensibles aux électrons de même dimension.

5. Microscope électronique à balayage selon une des revendications 1-4, dans lequel les détecteurs d'électrons (15, 16, 17, 18) sont des diodes.

6. Microscope électronique à balayage selon une des revendications 1-5, dans lequel le trou entre les détecteurs (15, 16, 17, 18) dans le premier plan (25) présente un diamètre ou une longueur de l'arête de <1 mm.

7. Microscope électronique à balayage selon une des revendications 1-6, dans lequel les surfaces sensibles aux électrons des détecteurs (15, 16, 17, 18) disposés dans le premier plan à l'extérieur du trou (19) sont mutuellement contiguës, de telle sorte que les zones insensibles aux électrons qui apparaissent entre les détecteurs présentent des dimensions de moins de 200 µm perpendiculairement aux bords des détecteurs.

8. Microscope électronique à balayage selon une des revendications 1-7, dans lequel on a prévu un traitement du signal permettant une génération d'image dans au moins cinq modes, un premier mode n'ayant recours pour la génération des images qu'au signal de l'autre détecteur (27), un deuxième mode ayant recours pour la génération des images à la somme des signaux des premiers détecteurs (15, 16, 17, 18), le troisième et le quatrième mode ayant recours pour la génération des images à des signaux sélectionnables d'un seul des premiers détecteurs (15), (16) des détecteurs (15, 16, 17, 18) disposés dans le premier plan (25) ou à la somme de deux des détecteurs (15, 16, 17, 18) disposés dans le premier plan, et un cinquième mode ayant recours pour la génération des images à la somme des signaux des détecteurs (15, 16, 17, 18) disposés dans le premier plan et du détecteur (27) disposé dans le deuxième plan (26).

9. Microscope électronique à balayage selon une des revendications 1-8, dans lequel le système détecteur comporte quatre détecteurs d'électrons (15, 16, 17, 18) qui sont disposés dans le premier plan (25), les quatre détecteurs d'électrons (15, 16, 17, 18) étant disposés décalés les uns par rapport aux autres de manière à former entre les détecteurs d'électrons, un trou (19) pour un libre passage d'un faisceau électronique.

10. Microscope électronique à balayage selon une des revendications 1-9, dans lequel les quatre détecteurs d'électrons (15, 16, 17, 18) du premier plan, comportent des surfaces sensibles aux électrons de forme rectangulaire ou carrée.

11. Microscope électronique à balayage selon une des revendications 1-10, dans lequel le trou (19) pour le libre passage d'électrons est de forme carrée.

12. Microscope électronique à balayage selon une des revendications 1-11, dans lequel la distance entre le premier plan (25) et le deuxième plan (26) mesure entre 0,1 et 5 mm.

13. Microscope électronique à balayage selon une des revendications 1-12, dans lequel le trou (19) pour le libre passage d'électrons présente un diamètre ou une longueur de l'arête entre 0,05 et 1 mm.
